# EUROPEAN PATENT APPLICATION

(11) **EP 4 577 015 A2**
(43) Date of publication of application: **25.06.2025**
(21) Application number: 24215538.0
(22) Date of filing: 26.11.2024
(51) Int. Cl.: H10K 50/11, H10K 59/12, H10K 59/122, H10K 59/35

(54) **DISPLAY DEVICE AND METHOD OF MANUFACTURING THE SAME**

(30) Priority: 18.12.2023 KR 20230185084
(71) Applicant: Samsung Display Co., Ltd., Yongin-si, Gyeonggi-do 17113 (KR)
(72) Inventor: Shin, Hyuneok, 17113 Yongin-si, Gyeonggi-do (KR); Kim, Arong, 17113 Yongin-si, Gyeonggi-do (KR); So, Byungsoo, 17113 Yongin-si, Gyeonggi-do (KR); Song, Seungyong, 17113 Yongin-si, Gyeonggi-do (KR); Lee, Juhyun, 17113 Yongin-si, Gyeonggi-do (KR); Lee, Changhee, 17113 Yongin-si, Gyeonggi-do (KR); Jang, Keunho, 17113 Yongin-si, Gyeonggi-do (KR)
(74) Representative: Gulde & Partner

(57) **Abstract**

A display device (1) includes a pixel circuit layer (PCL) disposed on a substrate (100), and a display element layer (DEL) disposed on the pixel circuit layer (PCL), wherein the display element layer (DEL) includes a first light-emitting element (ED1), a second light-emitting element (ED2), and a third light-emitting element (ED3) which are spaced apart from one another, and a bank layer (117) arranged between the first light-emitting element (ED1), the second light-emitting element (ED2), and the third light-emitting element (ED3).

## Description

### BACKGROUND

### 1. Technical Field

The present disclosure relates to an apparatus and a method, and more particularly, to a display device and a method of manufacturing the display device.

### 2. Description of the Related Art

Portability-based electronic devices have been widely used. In addition to compact electronic devices such as mobile phones, tablet personal computers (PCs) have recently been widely used as mobile electronic devices.

Such mobile electronic devices include display devices to support various functions and provide users with visual information such as images or video. Recently, as other components for driving display devices become smaller, the proportion of a display device in an electronic device is gradually increasing, and structures that can be bent to a certain angle from a flat state are also under development.

### SUMMARY

The invention is defined by the appended claims. The description that follows is subjected to this limitation. Any disclosure lying outside the scope of said claims is only intended for illustrative as well as comparative purposes.

One or more embodiments include a display device, which may be manufactured with a reduced number of deposition masks to manufacture the display device.

However, such an objective is an example, and the objective to be solved by the disclosure is not limited thereto.

Additional aspects will be set forth in part in the description which follows and, in part, will be apparent from the description, or may be learned by practice of the presented embodiments of the disclosure.

According to one or more embodiments, a display device includes a pixel circuit layer disposed on a substrate, and a display element layer disposed on the pixel circuit layer, wherein the display element layer includes a first light-emitting element, a second light-emitting element, and a third light-emitting element, which are spaced apart from one another, and a bank layer arranged between the first light-emitting element, the second light-emitting element, and the third light-emitting element, the first light-emitting element includes a first pixel electrode, a first intermediate layer disposed on the first pixel electrode, and a first common electrode disposed on the first intermediate layer, the second light-emitting element includes a second pixel electrode, a second intermediate layer disposed on the second pixel electrode, and a second common electrode disposed on the second intermediate layer, the third light-emitting element includes a third pixel electrode, a third intermediate layer disposed on the third pixel electrode, and a third common electrode disposed on the third intermediate layer, and a height of each of the first intermediate layer, the second intermediate layer, and the third intermediate layer is greater than a height of the bank layer.

In the present disclosure, the thickness of the first intermediate layer, the second intermediate layer and the third intermediate layer and the thickness of the bank layer may be the same or different while the height of the first intermediate layer, the second intermediate layer and the third intermediate layer with respect to a thickness direction, e. g. a z-axis direction, is greater than the height of the bank layer. In other words, the first intermediate layer, the second intermediate layer and the third intermediate layer are a projection in relation to the bank layer or stand out in relation to a surface or plane defined by the bank layer.

In other words, the respective heights of the first intermediate layer, the second intermediate layer, and the third intermediate layer may be identical to one another. Furthermore, the heights of the first intermediate layer, the second intermediate layer, and the third intermediate layer may be greater than the height of the bank layer.

In an embodiment, the bank layer may be in contact with side surfaces of the first pixel electrode, the second pixel electrode, and the third pixel electrode. The bank layer may insulate the first pixel electrode, the second pixel electrode, and the third pixel electrode so as not to be electrically connected to one another. Furthermore, the bank layer may be in contact with the side surfaces of the first intermediate layer, the second intermediate layer, and the third intermediate layer. The bank layer may insulate the first intermediate layer, the second intermediate layer, and the third intermediate layer so as not to be electrically connected to one another. The bank layer may include an organic insulating material and/or an inorganic insulating material.

In an embodiment, the first common electrode, the second common electrode, and the third common electrode may be electrically connected to one another.

In an embodiment, the first common electrode, the second common electrode, and the third common electrode may be integral with each other. In other words, the first common electrode, the second common electrode, and the third common electrode may be integrally formed to entirely cover the substrate. The common electrode may be disposed on the bank layer. In other words, the common electrode may be in contact with an upper surface of the bank layer. A difference in the height of the common electrode may be reduced due to the arrangement of the bank layer. In this structure, a short-circuit or disconnection of the common electrode may be reduced.

In an embodiment, the first pixel electrode and the first intermediate layer may be electrically connected to each other without forming a step. In other words, end portions of the first pixel electrode and the first intermediate layer may match each other. In other words, side surfaces of the first pixel electrode and the first intermediate layer may be formed on a same plane.

In an embodiment, the second pixel electrode and the second intermediate layer may be electrically connected to each other without forming a step. In other words, end portions of the second pixel electrode and the second intermediate layer may match each other. In other words, side surfaces of the second pixel electrode and the second intermediate layer may be formed on a same plane.

In an embodiment, the third pixel electrode and the third intermediate layer may be electrically connected to each other without forming a step. In other words, end portions of the third pixel electrode and the third intermediate layer may match each other. In other words, side surfaces of the third pixel electrode and the third intermediate layer may be formed on a same plane.

In an embodiment, the first light-emitting element, the second light-emitting element, and the third light-emitting element may emit light of different colors. In other words, the first light-emitting element, the second light-emitting element, and the third light-emitting element may be configured to emit light of different colors.

According to one or more embodiments, a method of manufacturing a display device includes arranging a pixel circuit layer on a substrate, and arranging a display element layer on the pixel circuit layer, wherein the arranging of the display element layer includes arranging a pixel electrode layer on the pixel circuit layer, arranging a first intermediate layer on the pixel electrode layer, arranging a first sacrificial layer on the first intermediate layer, patterning the first intermediate layer and the first sacrificial layer, and forming a first pixel electrode to overlap the first sacrificial layer, by patterning the pixel electrode layer.

In an embodiment, the forming of the first pixel electrode may include etching the pixel electrode layer by using the first sacrificial layer as a mask.

In an embodiment, the first pixel electrode and the first intermediate layer may be electrically connected to each other without forming a step. In other words, end portions of the first pixel electrode and the first intermediate layer may match each other. In other words, side surfaces of the first pixel electrode and the first intermediate layer may be formed on a same plane.

In an embodiment, the arranging of the display element layer may further include arranging a second intermediate layer on the pixel electrode layer, arranging a second sacrificial layer on the second intermediate layer, patterning the second intermediate layer and the second sacrificial layer, and forming a second pixel electrode to overlap the second sacrificial layer, by patterning the pixel electrode layer. The forming of the first pixel electrode and forming the second pixel electrode may be simultaneously performed.

In an embodiment, the forming of the second pixel electrode may include etching the pixel electrode layer by using the second sacrificial layer as a mask.

In an embodiment, the second pixel electrode and the second intermediate layer may be electrically connected to each other without forming a step. In other words, end portions of the second pixel electrode and the second intermediate layer may match each other. In other words, side surfaces of the second pixel electrode and the second intermediate layer may be formed on a same plane.

In an embodiment, the arranging of the display element layer may further include arranging a third intermediate layer on the pixel electrode layer, arranging a third sacrificial layer on the third intermediate layer, patterning the third intermediate layer and the third sacrificial layer, and forming a third pixel electrode to overlap the third sacrificial layer, by patterning the pixel electrode layer. The forming of the second pixel electrode and the forming of the third pixel electrode may be simultaneously performed.

In an embodiment, the forming of the third pixel electrode may include etching the pixel electrode layer by using the third sacrificial layer as a mask.

In an embodiment, the third pixel electrode and the third intermediate layer may be connected to each other without forming a step. In other words, end portions of the third pixel electrode and the third intermediate layer may match each other. In other words, side surfaces of the third pixel electrode and the third intermediate layer may be formed on a same plane.

In an embodiment, the arranging of the display element layer may further include arranging a bank layer on the pixel circuit layer to cover each of the first sacrificial layer, the second sacrificial layer, and the third sacrificial layer.

In an embodiment, the arranging of the display element layer may further include etching the bank layer to expose portions of the first intermediate layer, the second intermediate layer, and the third intermediate layer. The bank layer may be arranged between portions of the first intermediate layer, the second intermediate layer, and the third intermediate layer.

In an embodiment, the height of each of the first intermediate layer, the second intermediate layer, and the third intermediate layer may be greater than the height of the bank layer that is etched.

In an embodiment, the bank layer may be in contact with side surfaces of the first pixel electrode, the second pixel electrode, and the third pixel electrode. The bank layer may insulate the first pixel electrode, the second pixel electrode, and the third pixel electrode so as not to be electrically connected to one another.

In an embodiment, the bank layer may be in contact with the side surfaces of the first intermediate layer, the second intermediate layer, and the third intermediate layer. The bank layer may insulate the first intermediate layer, the second intermediate layer, and the third intermediate layer so as not to be electrically connected to one another.

In an embodiment, the bank layer may include an organic insulating material and/or an inorganic insulating material.

In an embodiment, the arranging of the display element layer may further include removing each of the first sacrificial layer, the second sacrificial layer, and the third sacrificial layer.

In an embodiment, the arranging of the display element layer may further include arranging a common electrode on the bank layer to cover the first intermediate layer, the second intermediate layer, and the third intermediate layer.

In an embodiment, the common electrode may be electrically connected to each of the first intermediate layer, the second intermediate layer, and the third intermediate layer.

In an embodiment, the common electrode may be disposed on the bank layer. In other words, the common electrode may be in contact with an upper surface of the bank layer. A difference in the height of the common electrode may be reduced due to the arrangement of the bank layer. In this structure, a short-circuit or disconnection of the common electrode may be reduced.

In other words, the method may be directed to manufacturing a display device according to the invention. In other words, the first light-emitting element, the second light-emitting element, and the third light-emitting element may be manufactured, wherein they are spaced apart and the respective result of arranging the pixel electrode layer on the pixel circuit layer, arranging the first, second and third intermediate layer on the pixel electrode layer, arranging the first, second and third sacrificial layer on the first, second and third intermediate layer, respectively, patterning the first, second and third intermediate layer and the first, second and third sacrificial layer, respectively, and forming the first, second and third pixel electrode to overlap the first, second and third sacrificial layer, respectively, by patterning the pixel electrode layer, followed by arranging the bank layer on the pixel circuit layer, etching the bank layer, removing each of the first sacrificial layer, the second sacrificial layer, and the third sacrificial layer, and arranging the common electrode. The arranged display element layer may include the first light-emitting element, the second light-emitting element, and the third light-emitting element which are spaced apart from one another. The method may include manufacturing the first light-emitting element including the first pixel electrode, the first intermediate layer disposed on the first pixel electrode, and a first common electrode disposed on the first intermediate layer. The arranged display element layer may include the second light-emitting element including the second pixel electrode, the second intermediate layer disposed on the second pixel electrode, and a second common electrode disposed on the second intermediate layer. The arranged display element layer may include the third light-emitting element including the third pixel electrode, the third intermediate layer disposed on the third pixel electrode, and a third common electrode disposed on the third intermediate layer. A height of each of the first intermediate layer, the second intermediate layer, and the third intermediate layer may be greater than a height of the bank layer.

In an embodiment, the first common electrode, the second common electrode, and the third common electrode may be integral with each other to form the common electrode. In other words, the first common electrode, the second common electrode, and the third common electrode may be integrally formed to entirely cover the substrate.

In an embodiment, the method of manufacturing a display device may include arranging an encapsulation layer on the display element layer.

In an embodiment, the arranging an encapsulation layer on the display element layer may include disposing a first inorganic encapsulation layer on the display element layer, and disposing an organic encapsulation layer on the first inorganic encapsulation layer, and disposing a second inorganic encapsulation layer on the organic encapsulation layer.

In an embodiment, the patterning of the intermediate layers and the sacrificial layers may include a photolithography process using a photoresist layer disposed on the sacrificial layers that is patterned.

In an embodiment, the intermediate layers and the sacrificial layers may be dry-etched by using an etching gas.

In an embodiment, the pixel electrode layer may be dry-etched by using an etching gas. In this state, the first sacrificial layer, the second sacrificial layer, and/or the third sacrificial layer may function as a mask.

In an embodiment, the forming of the first pixel electrode may include etching the pixel electrode layer by using the first sacrificial layer as a mask. The forming of the second pixel electrode may include etching the pixel electrode layer by using the second sacrificial layer as a mask. The forming of the third pixel electrode may include etching the pixel electrode layer by using the third sacrificial layer as a mask. The forming of the first pixel electrode, the forming of the second pixel electrode, and the forming of the third pixel electrode may be simultaneously performed.

Other aspects, features, and advantages than those described above will become apparent from the following drawings, claims, and detailed description of the disclosure

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic plan view of a display device according to an embodiment;
FIG. 2 is a schematic cross-sectional view of a display device according to an embodiment;
FIG. 3 is a schematic diagram of an equivalent circuit of any one pixel of a display device according to an embodiment;
FIG. 4 is a schematic flowchart of a method of manufacturing a display device, according to an embodiment;
FIG. 5 is a schematic flowchart of an operation of arranging a display element layer on a pixel circuit layer, according to an embodiment; and
FIGS. 6 to 24 are schematic cross-sectional views of a portion of a display device.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects of the description.

The term "and/or" includes all combinations of one or more of which associated configurations may define. For example, "A and/or B" may be understood to mean "A, B, or A and B."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

Various modifications may be applied to the embodiments, and particular embodiments will be illustrated in the drawings and described in the detailed description section. The effect and features of the embodiments, and a method to achieve the same, will be clearer referring to the detailed descriptions below with the drawings. However, the embodiments may be implemented in various forms, not by being limited to the embodiments presented below.

Hereinafter, embodiments will be described in detail with reference to the accompanying drawings, and in the description with reference to the drawings, the same or corresponding constituents may be indicated by the same reference numerals or characters and redundant descriptions thereof are omitted.

In the following embodiment, it will be understood that although the terms first, second, etc. may be used herein to describe various elements, these elements should not be limited by these terms. These elements are only used to distinguish one element from another.

In the following embodiment, as used herein, the singular forms, such as "a" and "an," are intended to include the plural forms as well, unless the context clearly indicates otherwise.

In the following embodiment, it will be further understood that the terms "comprises," "includes," "has," and/or their variants used herein specify the presence of stated features or elements, but do not preclude the presence or addition of one or more other features or components.

In the following embodiment, it will be understood that when an element, such as a layer, a film, a region, or a plate, is referred to as being "on" another element, the element can be directly on the other element or intervening elements may be present thereon.

Sizes of elements in the drawings may be exaggerated for convenience of explanation. For example, since sizes and thicknesses of elements in the drawings are arbitrarily illustrated for convenience of explanation, the following embodiments are not limited thereto.

In the following embodiment, the x-axis, the y-axis, and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

When a certain embodiment is implemented differently, a specific process order may be performed differently from the described order. For example, two consecutively described processes may be performed substantially at the same time or performed in an order opposite to the described order.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

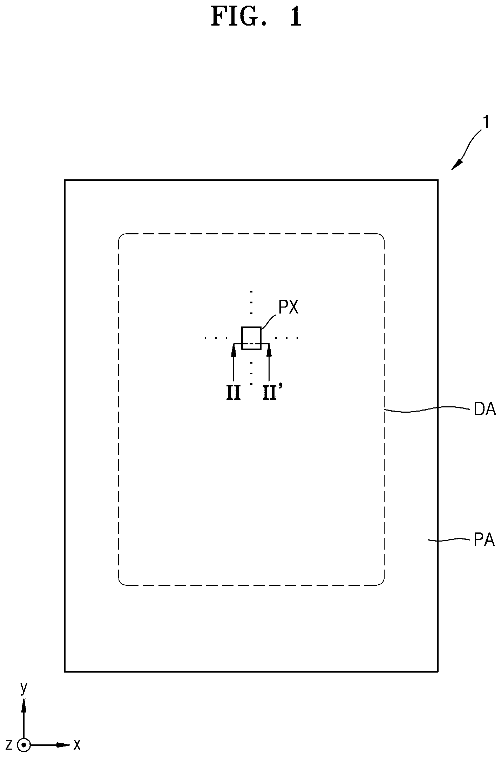

FIG. 1 is a schematic plan view of a display device 1 according to an embodiment.

Referring to FIG. 1, the display device 1 manufactured according to an embodiment may include a display area DA and a peripheral area PA located outside the display area DA. The display device 1 may provide an image through an array of one or more pixels PX arranged two-dimensionally in the display area DA.

The peripheral area PA, which is an area that does not provide an image, may be adjacent to the display area DA or surround entirely or partially the display area DA. A driver or the like for providing an electrical signal or power to a pixel circuit corresponding to each of the pixels PX may be arranged in the peripheral area PA. A pad area that is an area to which an electronic device, a printed circuit board, or the like may be electrically connected may be disposed in the peripheral area PA.

In an embodiment, the display device 1 may include an organic light-emitting diode (OLED) as a light-emitting element, but the display device 1 according to one or more embodiments is not limited thereto. In another embodiment, the display device 1 may be a light-emitting display device including an inorganic light-emitting diode, for example, an inorganic light-emitting display device. The inorganic light-emitting diode may include a PN diode including inorganic semiconductor-based materials. In case that a voltage is applied to a PN junction diode in a forward direction, holes and electrons are injected, and energy generated by a recombination of the holes and electrons may be converted into light energy, thereby emitting light of a certain color. The inorganic light-emitting diode described above may have a width of several to hundreds of micrometers, and in some embodiments, the inorganic light-emitting diode may be referred to as a micro light-emitting diode (LED). In another embodiment, the display device 1 may be a quantum-dot light-emitting display device.

The display device 1 may be used as display screens of various products including not only portable electronic devices, such as mobile phones, smart phones, tablet personal computers (PCs), mobile communication terminals, electronic organizers, electronic books, portable multimedia players (PMPs), navigation devices, ultra-mobile PCs (UMPCs), and the like, but also televisions, laptop computers, monitors, billboards, Internet of things (IOT) devices, and the like. Furthermore, the display device 1 according to an embodiment may be used for wearable devices, such as smart watches, watch phones, glasses-type displays, and head mounted displays (HMDs). Furthermore, the display apparatus 1 according to an embodiment may be used as an instrument panel of a vehicle, a center information display (CID) disposed in the center fascia or dashboard of a vehicle, a room mirror display in lieu of a side mirror of a vehicle, or a display screen disposed at the rear surface of a front seat as an entertainment device for a rear seat of a vehicle.

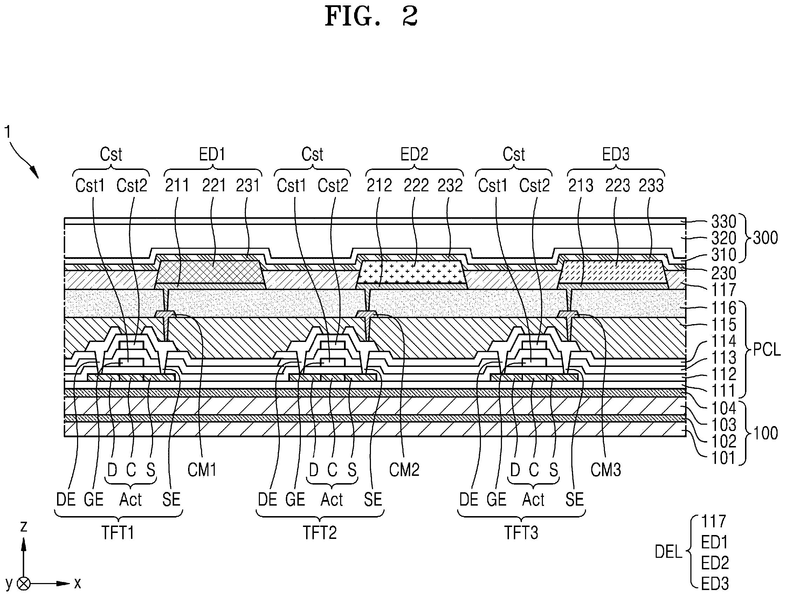

FIG. 2 is a schematic cross-sectional view of the display device 1 according to an embodiment, taken along line II-II' of FIG. 1.

Referring to FIG. 2, the display device 1 may include a substrate 100, a pixel circuit layer PCL, a display element layer DEL, and an encapsulation layer 300.

The substrate 100 may have a multilayer structure including a base layer including polymer resin and an inorganic layer. For example, the substrate 100 may include a base layer including polymer resin and a barrier layer that is an inorganic insulating layer. For example, the substrate 100 may include a first base layer 101, a first barrier layer 102, a second base layer 103, and/or a second barrier layer 104, which are sequentially stacked. The first base layer 101 and the second base layer 103 may include, for example, polyimide (PI), polyethersulfone (PES), polyarylate, polyetherimide (PEI), polyethylene naphthalate (PEN), polyethylene terephthalate (PET), polyphenylene sulfide (PPS), polycarbonate, cellulose triacetate (TAC), cellulose acetate propionate (CAP), or/and the like. The first barrier layer 102 and the second barrier layer 104 may each include an inorganic insulating material, such as a silicon oxide, a silicon oxynitride, and/or a silicon nitride. The substrate 100 may be flexible.

The pixel circuit layer PCL may be disposed on the substrate 100. The pixel circuit layer PCL may include a first thin film transistor TFT1, a second thin film transistor TFT2, and a third thin film transistor TFT3, which are spaced apart from one another. The first thin film transistor TFT1, the second thin film transistor TFT2, and the third thin film transistor TFT3 may each include a semiconductor layer Act, a gate electrode GE, a drain electrode DE, and a source electrode SE.

For example, the semiconductor layer Act may include polysilicon (poly-Si). As another example, the semiconductor layer Act may include amorphous silicon (a-Si), an oxide semiconductor, an organic semiconductor, or the like. The semiconductor layer Act may include a channel region C, and a drain region D and a source region S arranged in the opposite sides of the channel region C. The gate electrode GE may overlap the channel region C.

The gate electrode GE may include a low resistance metal material. The gate electrode GE may include a conductive material including, for example, molybdenum (Mo), aluminum (Al), copper (Cu), titanium (Ti), or the like, and may be formed in a multilayer or single layer including the material described above.

The drain electrode DE may be connected to the drain region D, and the source electrode SE may be connected to the source region S. The drain electrode DE and the source electrode SE may each include a material with excellent or desirable conductivity. The drain electrode DE and the source electrode SE may each include a conductive material, for example, including Mo, Al, Cu, Ti, or the like, and may each be formed in a multilayer or single layer including the material described above. In an embodiment, the drain electrode DE and the source electrode SE may each have a multilayer structure of Ti/Al/Ti.

The pixel circuit layer PCL may include a buffer layer 111, a first gate insulating layer 112, a second gate insulating layer 113, an interlayer insulating layer 114, a first planarization insulating layer 115, and a second planarization insulating layer 116.

The buffer layer 111 may reduce or prevent infiltration of foreign materials, moisture, or external air from under the substrate 100, and may provide a planarized surface on the substrate 100. The buffer layer 111 may include an inorganic insulating material, such as a silicon oxide, a silicon oxynitride, and a silicon nitride, and have a single layer or multilayer structure including the material(s) described above.

The semiconductor layer Act may be disposed on the buffer layer 111, and the first gate insulating layer 112 may be arranged between the semiconductor layer Act and the gate electrode GE. The first gate insulating layer 112 may include an inorganic insulating material, such as a silicon oxide (SiO₂), a silicon nitride (SiNx), a silicon oxynitride (SiON), an aluminum oxide (Al₂O₃), a titanium oxide (TiO₂), a tantalum oxide (Ta₂O₅), a hafnium oxide (HfO₂), a zinc oxide (ZnOx), or the like. For example, ZnOx may include a zinc oxide (ZnO) and/or a zinc peroxide (ZnO₂).

The second gate insulating layer 113 may cover (or overlap) the gate electrode GE. The second gate insulating layer 113 may include an inorganic insulating material, such as SiO₂, SiNx, SiON, Al₂O₃, TiO₂, Ta₂O₅, HfO₂, or ZnOx, similar to the first gate insulating layer 112. For example, ZnOx may include ZnO and/or ZnO₂.

An upper electrode Cst2 of a storage capacitor Cst may be disposed above the second gate insulating layer 113. The upper electrode Cst2 may overlap the gate electrode GE thereunder. In this state, the gate electrode GE and the upper electrode Cst2 overlapping each other with the second gate insulating layer 113 therebetween may form the storage capacitor Cst. In other words, the gate electrode GE may function as a lower electrode Cst1 of the storage capacitor Cst.

The upper electrode Cst2 may include Al, platinum (Pt), palladium (Pd), silver (Ag), magnesium (Mg), gold (Au), nickel (Ni), neodymium (Nd), iridium (Ir), chromium (Cr), calcium (Ca), Mo, Ti, tungsten (W), and/or Cu, and may be formed in a single layer or multilayer including the material described above.

The interlayer insulating layer 114 may cover (or overlap) the upper electrode Cst2. The interlayer insulating layer 114 may include SiO₂, SiNx, SiON, Al₂O₃, TiO₂, TazOs, HfO₂, ZnOx, or the like. For example, ZnOx may include ZnO, and/or ZnO₂. The interlayer insulating layer 114 may be a single layer or multilayer including the inorganic insulating material described above.

The drain electrode DE and the source electrode SE may each be disposed on the interlayer insulating layer 114. The drain electrode DE and the source electrode SE may be respectively connected to the drain region D and the source region S through contact holes formed in the insulating layers thereunder.

The first planarization insulating layer 115 may cover the drain electrode DE and the source electrode SE. The first planarization insulating layer 115 may include an organic insulating material, such as a general purpose polymer including polymethylmethacrylate (PMMA) or polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, and blends thereof.

The second planarization insulating layer 116 may be disposed on the first planarization insulating layer 115. The second planarization insulating layer 116 and the first planarization insulating layer 115 may include a same material, and the second planarization insulating layer 116 may include an organic insulating material, such as a general purpose polymer including polymethylmethacrylate (PMMA) or polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, and blends thereof.

The display element layer DEL may be disposed on the pixel circuit layer PCL. The display element layer DEL may include a first light-emitting element ED1, a second light-emitting element ED2, a third light-emitting element ED3, and/or a bank layer 117.

The first light-emitting element ED1 may emit first light, the second light-emitting element ED2 may emit second light, and the third light-emitting element ED3 may emit third light. The first light, the second light, and the third light may each be any one of red light, green light, and blue light. The first light-emitting element ED1, the second light-emitting element ED2, and the third light-emitting element ED3 may emit light of different colors. For example, the first light-emitting element ED1 may emit red light, the second light-emitting element ED2 may emit green light, and the first light-emitting element ED1 may emit blue light. However, this is an example, and the light emitted by the first light-emitting element ED1, the second light-emitting element ED2, and the third light-emitting element ED3 is not limited thereto.

The first light-emitting element ED1 may include a first pixel electrode 211, a first intermediate layer 221, and a first common electrode 231.

The first pixel electrode 211 may be disposed on the pixel circuit layer PCL. The first pixel electrode 211 may be disposed on the second planarization insulating layer 116. The first pixel electrode 211 may be electrically connected to the first thin film transistor TFT1 through contact holes formed in the second planarization insulating layer 116 and the first planarization insulating layer 115 and a first contact metal CM1 disposed on the first planarization insulating layer 115.

The first intermediate layer 221 may be disposed on the first pixel electrode 211. The first intermediate layer 221 may be in contact with the first pixel electrode 211. The first pixel electrode 211 and the first intermediate layer 221 may be connected to each other without forming a step. In other words, end portions of the first pixel electrode 211 and the first intermediate layer 221 may match each other. Furthermore, side surfaces of the first pixel electrode 211 and the first intermediate layer 221 may be formed on a same plane.

The first common electrode 231 may be disposed on the first intermediate layer 221. The first common electrode 231 may be in contact with an upper surface and a side surface of the first intermediate layer 221. The first common electrode 231 may overlap the first pixel electrode 211.

A second pixel electrode 212 may be disposed on the pixel circuit layer PCL. The second pixel electrode 212 may be disposed on the second planarization insulating layer 116. The second pixel electrode 212 may be electrically connected to the second thin film transistor TFT2 through contact holes formed in the second planarization insulating layer 116 and the first planarization insulating layer 115 and a second contact metal CM2 disposed on the first planarization insulating layer 115.

A second intermediate layer 222 may be disposed on the second pixel electrode 212. The second intermediate layer 222 may be in contact with the second pixel electrode 212. The second pixel electrode 212 and the second intermediate layer 222 may be connected to each other without forming a step. In other words, end portions of the second pixel electrode 212 and the second intermediate layer 222 may match each other. Furthermore, side surfaces of the second pixel electrode 212 and the second intermediate layer 222 may be formed on a same plane.

A second common electrode 232 may be disposed on the second intermediate layer 222. The second common electrode 232 may be in contact with an upper surface and a side surface of the second intermediate layer 222. The second common electrode 232 may overlap the second pixel electrode 212.

A third pixel electrode 213 may be disposed on the pixel circuit layer PCL. The third pixel electrode 213 may be disposed on the second planarization insulating layer 116. The third pixel electrode 213 may be electrically connected to the third thin film transistor TFT3 through contact holes formed in the first planarization insulating layer 115 and the second planarization insulating layer 116 and a third contact metal CM3 disposed on the first planarization insulating layer 115.

A third intermediate layer 223 may be disposed on the third pixel electrode 213. The third intermediate layer 223 may be in contact with the third pixel electrode 213. The third pixel electrode 213 and the third intermediate layer 223 may be connected to each other without forming a step. In other words, end portions of the third pixel electrode 213 and the third intermediate layer 223 may match each other. Furthermore, side surfaces of the third pixel electrode 213 and the third intermediate layer 223 may be formed on a same plane.

A third common electrode 233 may be disposed on the third intermediate layer 223. The third common electrode 233 may be in contact with an upper surface and a side surface of the third intermediate layer 223. The third common electrode 233 may overlap the third pixel electrode 213.

The first pixel electrode 211, the second pixel electrode 212, and the third pixel electrode 213 may each include conductive oxide, such as an indium tin oxide (ITO), an indium zinc oxide (IZO), a zinc oxide (ZnO), an indium oxide (In₂O₃), an indium gallium oxide (IGO), or an aluminum zinc oxide (AZO). In another embodiment, the first pixel electrode 211, the second pixel electrode 212, and the third pixel electrode 213 may each include a reflective film including Ag, Mg, Al, Pt, Pd, Au, Ni, Nd, Ir, Cr, or a compound (or combination) thereof. In another embodiment, the first pixel electrode 211, the second pixel electrode 212, and the third pixel electrode 213 may each further include a film formed of ITO, IZO, ZnO, or In₂O₃ above/below the reflective film described above.

The first intermediate layer 221, the second intermediate layer 222, and the third intermediate layer 223 may each include an emission layer, and the emission layer may include a polymer or low molecular weight organic material that emits light of a certain color. As another example, the emission layer may include an inorganic light-emitting material or quantum dots. The first intermediate layer 221, the second intermediate layer 222, and the third intermediate layer 223 may each include a hole transport layer (HTL) and/or a hole injection layer (HIL), which are arranged under the emission layer. Furthermore, the first intermediate layer 221, the second intermediate layer 222, and the third intermediate layer 223 may each include an electron transport layer (ETL) and/or an electron injection layer (EIL), which are arranged above the emission layer.

The first common electrode 231, the second common electrode 232, and the third common electrode 233 may be connected to one another to form a common electrode 230. In other words, the common electrode 230 may include the first common electrode 231, the second common electrode 232, and the third common electrode 233. The first common electrode 231, the second common electrode 232, and the third common electrode 233 may be integrally formed to entirely cover the substrate 100.

The common electrode 230 may include a conductive material having a low work function. For example, the common electrode 230 may include a (semi-)transparent layer including Ag, Mg, Al, Pt, Pd, Au, Ni, Nd, Ir, Cr, lithium (Li), Ca, or an alloy thereof, and the like. As another example, the common electrode 230 may further include a layer including ITO, IZO, ZnO, or In₂O₃ on the (semi-)transparent layer including the material described above.

The bank layer 117 may be disposed between the first light-emitting element ED1, the second light-emitting element ED2, and the third light-emitting element ED3. The bank layer 117 may be accommodated in spaces between the first intermediate layer 221, the second intermediate layer 222, and the third intermediate layer 223. In this state, the heights of the first intermediate layer 221, the second intermediate layer 222, and the third intermediate layer 223 may be identical to one another. Furthermore, the heights of the first intermediate layer 221, the second intermediate layer 222, and the third intermediate layer 223 may be greater than the height of the bank layer 117.

The bank layer 117 may be in contact with the side surfaces of the first pixel electrode 211, the second pixel electrode 212, and the third pixel electrode 213. The bank layer 117 may insulate the first pixel electrode 211, the second pixel electrode 212, and the third pixel electrode 213 so as not to be electrically connected to one another. Furthermore, the bank layer 117 may be in contact with the side surfaces of the first intermediate layer 221, the second intermediate layer 222, and the third intermediate layer 223. The bank layer 117 may insulate the first intermediate layer 221, the second intermediate layer 222, and the third intermediate layer 223 so as not to be electrically connected to one another. The bank layer 117 may include an organic insulating material and/or an inorganic insulating material.

The common electrode 230 may be disposed on the bank layer 117. In other words, the common electrode 230 may be in contact with an upper surface of the bank layer 117. A difference in the height of the common electrode 230 may be reduced due to the arrangement of the bank layer 117. In this structure, a short-circuit or disconnection of the common electrode 230 may be reduced.

The encapsulation layer 300 may be disposed on the display element layer DEL. The encapsulation layer 300 may cover (or overlap) the display element layer DEL. The encapsulation layer 300 may include at least one inorganic encapsulation layer and at least one organic encapsulation layer, and in an embodiment, FIG. 2 illustrates that the encapsulation layer 300 includes a first inorganic encapsulation layer 310, an organic encapsulation layer 320, and/or a second inorganic encapsulation layer 330, which are sequentially stacked.

The first inorganic encapsulation layer 310 and the second inorganic encapsulation layer 330 may each include one or more inorganic materials of an aluminum oxide, a titanium oxide, a tantalum oxide, a hafnium oxide, a zinc oxide, a silicon oxide, a silicon nitride, and a silicon oxynitride. The organic encapsulation layer 320 may include a polymer-based material. The polymer -based material may include acrylic resin, epoxy-based resin, polyimide, polyethylene, and the like. In an embodiment, the organic encapsulation layer 320 may include acrylate. The organic encapsulation layer 320 may be formed by curing a monomer or applying a polymer. The organic encapsulation layer 320 may be transparent.

Although not illustrated, a touch sensor layer may be disposed on the encapsulation layer 300, and an optical functional layer may be disposed on the touch sensor layer. The touch sensor layer may obtain coordinate information according to an external input, for example, a touch event. The optical functional layer may reduce reflectivity of light (external light) externally input toward the display device 1, and/or improve color purity of light emitted from the display device 1. In an embodiment, the optical functional layer may include a retarder and/or a polarizer. The retarder may be a film type or a liquid crystal coating type, and may include, for example, a λ/2 retarder and/or a λ/4 retarder. The polarizer may also be a film type or a liquid crystal coating type. The film type may include a stretchable synthetic resin film, and the liquid crystal coating type may include liquid crystals arranged in a certain array. The retarder and the polarizer may each further include a protective film.

An adhesive member may be disposed between the touch electrode layer and the optical functional layer. The adhesive member may employ any general one in the art without limitation. For example, the adhesive member may include a pressure sensitive adhesive (PSA).

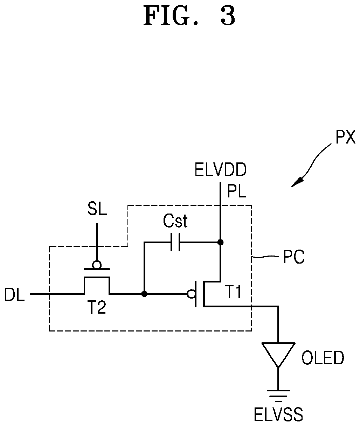

FIG. 3 is a schematic diagram of an equivalent circuit of any one pixel of the display device 1 according to an embodiment.

Each pixel PX may include a pixel circuit PC and a display element, for example, an organic light-emitting diode OLED, connected to the pixel circuit PC. The pixel circuit PC may include a driving thin film transistor T1, a switching thin film transistor T2, and the storage capacitor Cst. Each pixel PX may emit, for example, red, green, blue, or white light through the organic light-emitting diode OLED.

The switching thin film transistor T2 may be connected to a scan line SL and a data line DL, and may transmit, to the driving thin film transistor T1, a data voltage input through the data line DL based on a switching voltage input through the scan line SL. The storage capacitor Cst may be connected to the switching thin film transistor T2 and a driving voltage line PL, and may store a voltage corresponding to a difference between a voltage received from the switching thin film transistor T2 and a first power voltage ELVDD supplied to the driving voltage line PL.

The driving thin film transistor T1 may be connected to the driving voltage line PL and the storage capacitor Cst, and may control a driving current flowing in the organic light-emitting diode OLED from the driving voltage line PL, in response to a voltage value stored in the storage capacitor Cst. The organic light-emitting diode OLED may emit light having a certain luminance based on the driving current. A counter electrode (e.g., a cathode) of the organic light-emitting diode OLED may receive a second power voltage ELVSS.

Although FIG. 3 illustrates that the pixel circuit PC includes two thin film transistors and one storage capacitor, the disclosure is not limited thereto. The number of thin film transistors and the number of storage capacitors may be variously changed according to a design of the pixel circuit PC. For example, the pixel circuit PC may further include four or five or more thin film transistors, in addition to the two thin film transistors described above.

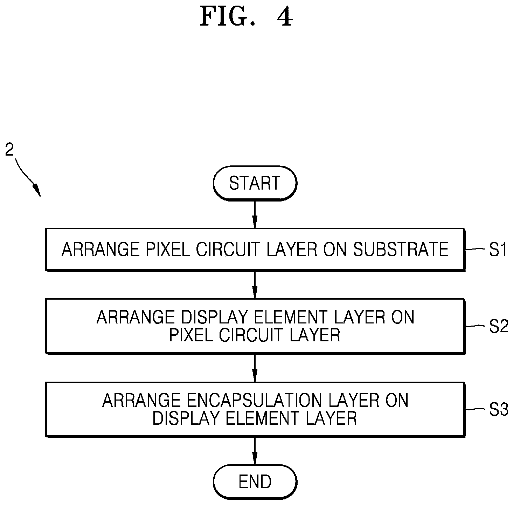

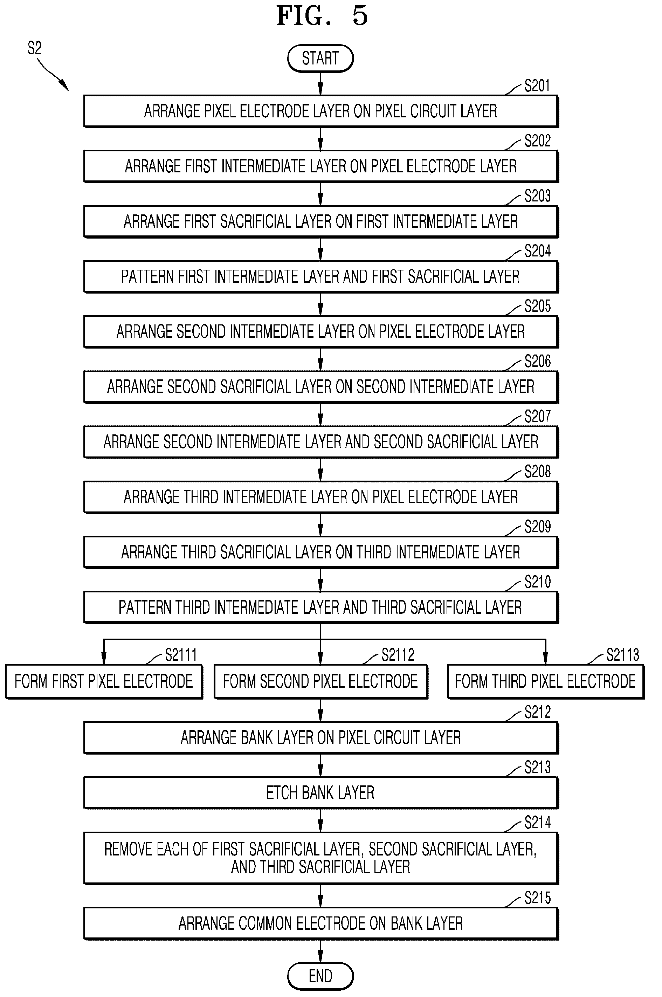

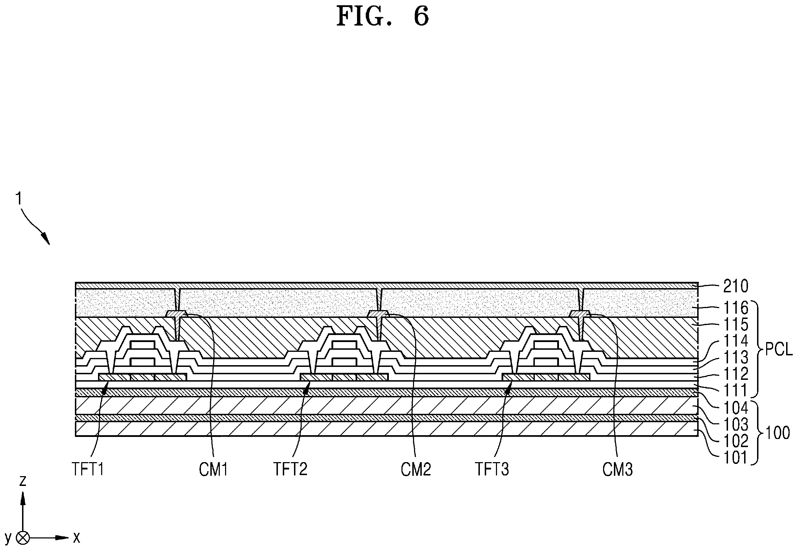

FIG. 4 is a schematic flowchart of a method 2 of manufacturing a display device, according to an embodiment. FIG. 5 is a schematic flowchart of an operation of arranging the display element layer DEL on the pixel circuit layer PCL (S2), according to an embodiment. FIGS. 6 to 24 are schematic cross-sectional views of a portion of the display device 1.

Referring to FIGS. 4 to 24, it may be seen that the method 2 of manufacturing a display device is to manufacture the display device 1 described with reference to FIGS. 1 to 3.

In FIGS. 4 to 24, as the same reference numerals/characters as those used in FIGS. 1 to 3 may indicate the same members, redundant descriptions thereof are omitted.

Referring to FIGS. 4 and 6, the method 2 of manufacturing a display device may include arranging the pixel circuit layer PCL on the substrate 100 (S1).

The substrate 100 may have a multilayer structure including a base layer including polymer resin and an inorganic layer. For example, the substrate 100 may include a base layer including polymer resin and a barrier layer that is an inorganic insulating layer. For example, the substrate 100 may include the first base layer 101, the first barrier layer 102, the second base layer 103, and/or the second barrier layer 104, which are sequentially stacked.

The pixel circuit layer PCL may be disposed on the substrate 100. The pixel circuit layer PCL may include the first thin film transistor TFT1, the second thin film transistor TFT2, and the third thin film transistor TFT3, which are spaced apart from each other. Furthermore, the pixel circuit layer PCL may include the buffer layer 111, the first gate insulating layer 112, the second gate insulating layer 113, the interlayer insulating layer 114, the first planarization insulating layer 115, and/or the second planarization insulating layer 116.

Referring to FIGS. 4 to 23, the method 2 of manufacturing a display device may include the arranging of the display element layer DEL on the pixel circuit layer PCL (S2).

First, referring to FIGS. 5 and 6, the arranging of the display element layer DEL on the pixel circuit layer PCL (S2) may include arranging a pixel electrode layer 210 on the pixel circuit layer PCL (S201).

The pixel electrode layer 210 may be disposed on the pixel circuit layer PCL, and may be connected to each of the first thin film transistor TFT1, the second thin film transistor TFT2, and the third thin film transistor TFT3.

The pixel electrode layer 210 may be electrically connected to the first thin film transistor TFT1, through contact holes formed in the second planarization insulating layer 116 and the first planarization insulating layer 115 and the first contact metal CM1 disposed on the first planarization insulating layer 115.

Furthermore, the pixel electrode layer 210 may be electrically connected to the second thin film transistor TFT2, through contact holes formed in the second planarization insulating layer 116 and the first planarization insulating layer 115 and the second contact metal CM2 disposed on the first planarization insulating layer 115.

The pixel electrode layer 210 may be electrically connected to the third thin film transistor TFT3, through contact holes formed in the second planarization insulating layer 116 and the first planarization insulating layer 115 and the third contact metal CM3 disposed on the first planarization insulating layer 115.

The pixel electrode layer 210 may include a conductive oxide, such as ITO, IZO, ZnO, In₂O₃, IGO, or AZO. In another embodiment, the pixel electrode layer 210 may include a reflective film including, for example, Ag, Mg, Al, Pt, Pd, Au, Ni, Nd, Ir, Cr, or a compound thereof. In another embodiment, the pixel electrode layer 210 may further include a film formed of ITO, IZO, ZnO, or In₂O₃ above/below the reflective film described above.

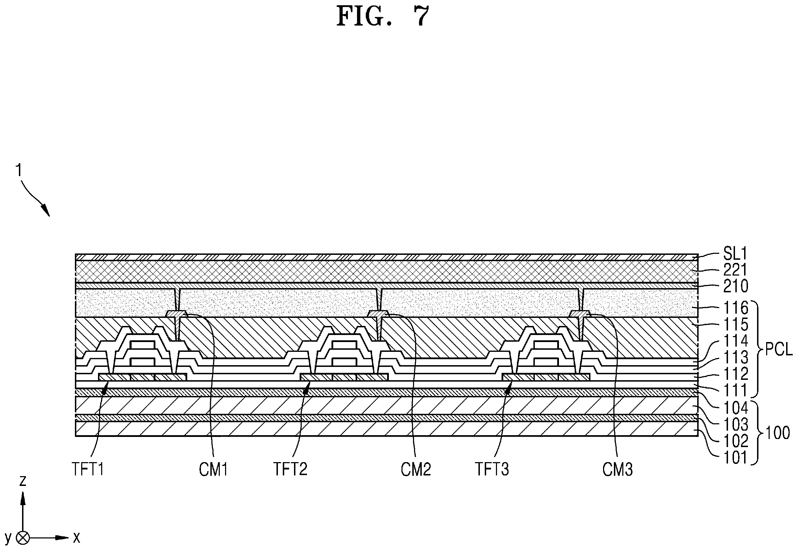

Referring to FIGS. 5 and 7, the arranging of the display element layer DEL on the pixel circuit layer PCL (S2) may include arranging the first intermediate layer 221 on the pixel electrode layer 210 (S202) and arranging a first sacrificial layer SL1 on the first intermediate layer 221 (S203).

The first intermediate layer 221 may be disposed on the pixel electrode layer 210 to cover (or overlap) the pixel electrode layer 210. The first sacrificial layer SL1 may be disposed on the first intermediate layer 221 to cover the first intermediate layer 221. The first sacrificial layer SL1 may include at least one material of IZO and an indium gallium zinc oxide (IGZO).

Referring to FIG. 5 and FIGS. 8 to 10, the arranging of the display element layer DEL on the pixel circuit layer PCL (S2) may include patterning the first intermediate layer 221 and the first sacrificial layer SL1 (S204). The patterning of the first intermediate layer 221 and the first sacrificial layer SL1 (S204) may include a photolithography process.

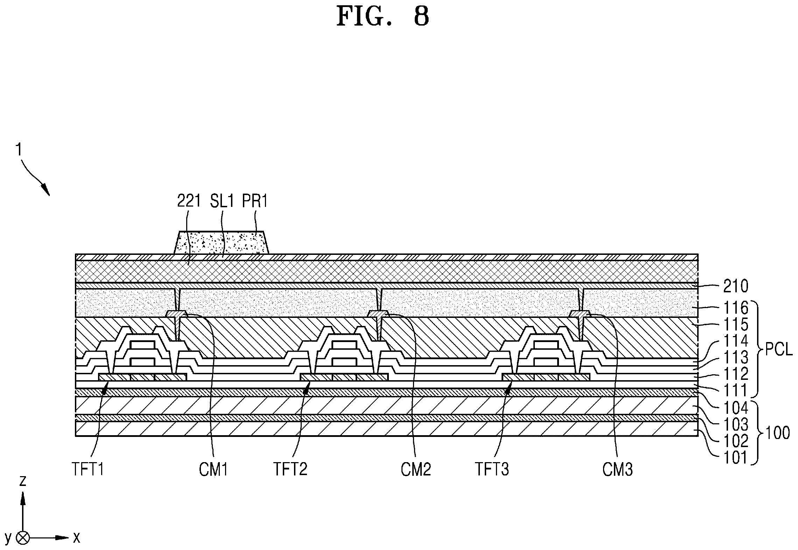

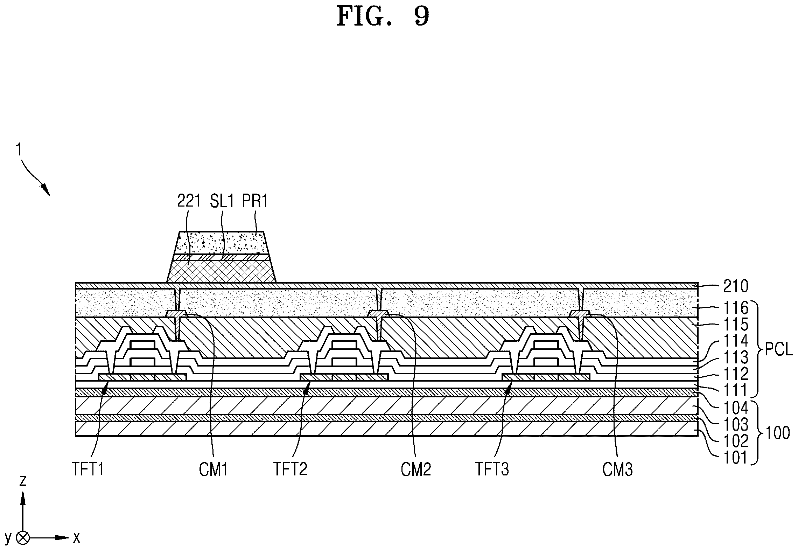

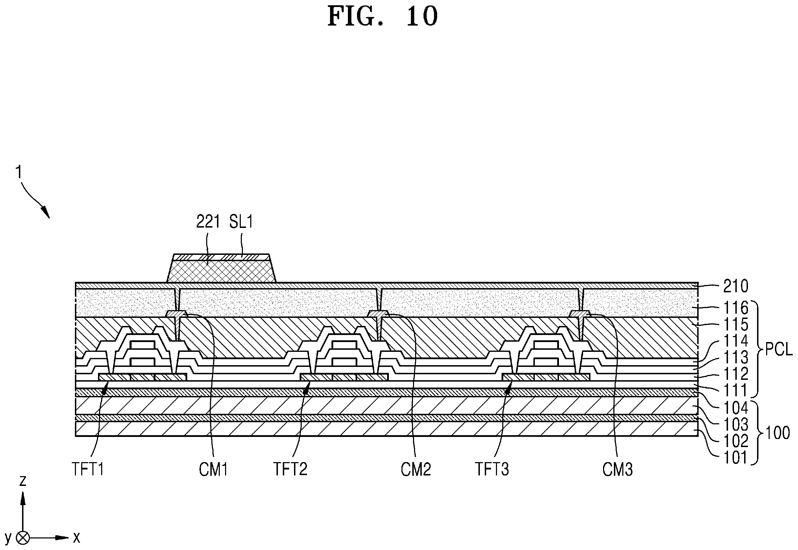

Referring to FIG. 8, a first photoresist layer PR1 that is patterned may be disposed on the first sacrificial layer SL1. Referring to FIG. 9, the first intermediate layer 221 and the first sacrificial layer SL1 may be etched. For example, the first intermediate layer 221 and the first sacrificial layer SL1 may be dry-etched by using an etching gas. In this process, the first intermediate layer 221 and the first sacrificial layer SL1, overlapping the first photoresist layer PR1, may remain. The first intermediate layer 221 and the first sacrificial layer SL1, which do not overlap the first photoresist layer PR1, may be etched and removed. Referring to FIG. 10, the first photoresist layer PR1 may be removed.

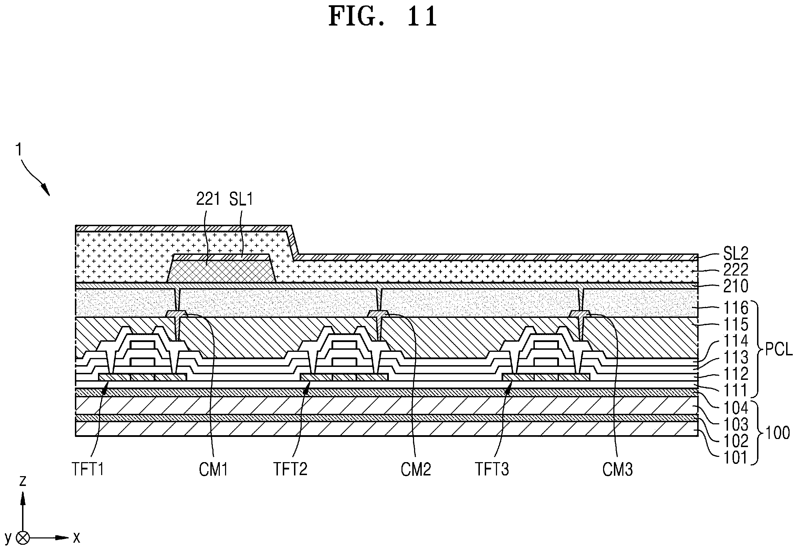

Referring to FIGS. 5 and 11, the arranging of the display element layer DEL on the pixel circuit layer PCL (S2) may include arranging the second intermediate layer 222 on the pixel electrode layer 210 (S205) and arranging a second sacrificial layer SL2 on the second intermediate layer 222 (S206).

The second intermediate layer 222 may be disposed on the pixel electrode layer 210 to cover (or overlap) the pixel electrode layer 210. A portion of the second intermediate layer 222 may be disposed on the first intermediate layer 221 and the first sacrificial layer SL1. The second sacrificial layer SL2 may be disposed on the second intermediate layer 222 to cover the second intermediate layer 222. The second sacrificial layer SL2 may include at least one material of IZO and IGZO.

Referring to FIG. 5 and FIGS. 12 to 14, the arranging of the display element layer DEL on the pixel circuit layer PCL (S2) may include patterning the second intermediate layer 222 and the second sacrificial layer SL2 (S207). The patterning of the second intermediate layer 222 and the second sacrificial layer SL2 (S207) may include a photolithography process.

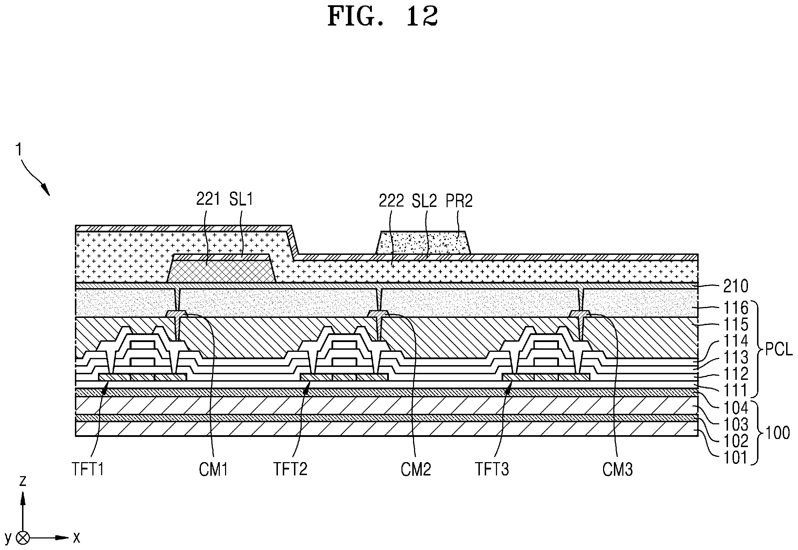

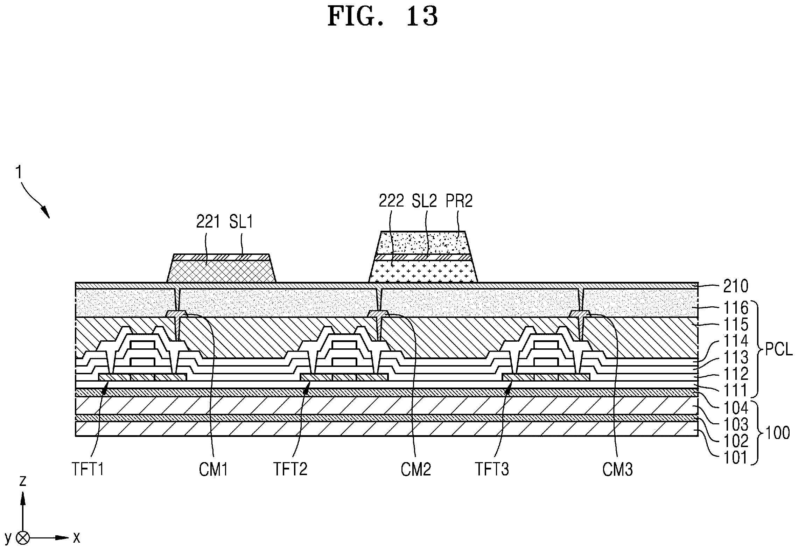

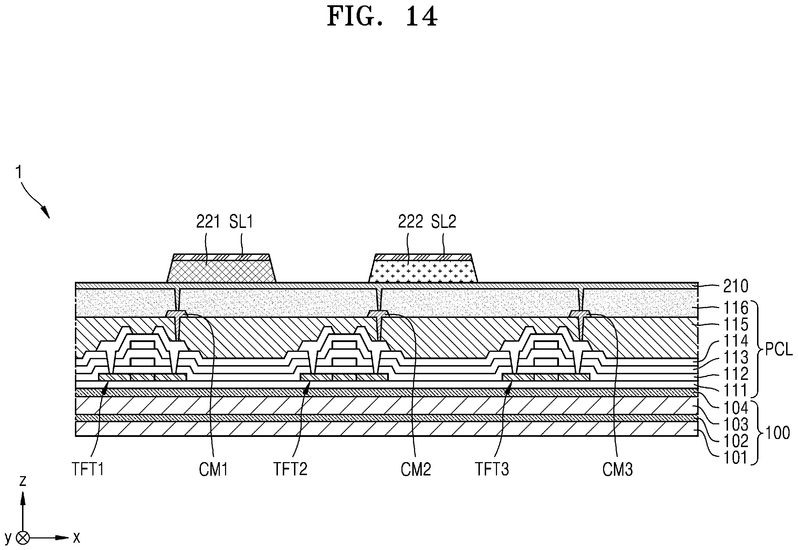

Referring to FIG. 12, a second photoresist layer PR2 that is patterned may be disposed on the second sacrificial layer SL2. Referring to FIG. 13, the second intermediate layer 222 and the second sacrificial layer SL2 may be etched. For example, the second intermediate layer 222 and the second sacrificial layer SL2 may be dry-etched by using an etching gas. In this process, the second intermediate layer 222 and the second sacrificial layer SL2, overlapping the second photoresist layer PR2, may remain. The second intermediate layer 222 and the second sacrificial layer SL2, which do not overlap the second photoresist layer PR2, may be etched and removed. Referring to FIG. 14, the second photoresist layer PR2 may be removed.

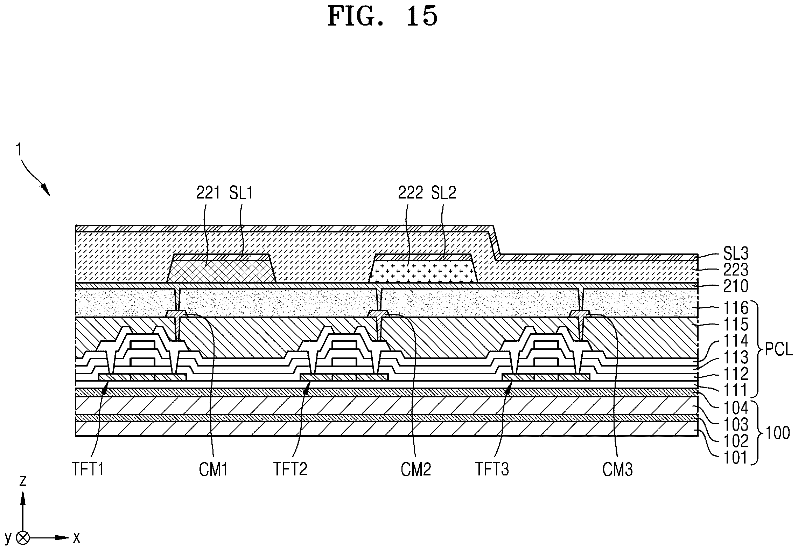

Referring to FIGS. 5 and 15, the arranging of the display element layer DEL on the pixel circuit layer PCL (S2) may include arranging the third intermediate layer 223 on the pixel electrode layer 210 (S208) and arranging a third sacrificial layer SL3 on the third intermediate layer 223 (S209).

The third intermediate layer 223 may be disposed on the pixel electrode layer 210 to cover (or overlap) the pixel electrode layer 210. A portion of the third intermediate layer 223 may be disposed on the first intermediate layer 221 and the first sacrificial layer SL1. Furthermore, a portion of the third intermediate layer 223 may be disposed on the second intermediate layer 222 and the second sacrificial layer SL2. The third sacrificial layer SL3 may be disposed on the third intermediate layer 223 to cover (or overlap) the third intermediate layer 223. The third sacrificial layer SL3 may include at least one material of IZO and IGZO.

Referring to FIG. 5 and FIGS. 16 to 18, the arranging of the display element layer DEL on the pixel circuit layer PCL (S2) may include patterning the third intermediate layer 223 and the third sacrificial layer SL3 (S210). The patterning of the third intermediate layer 223 and the third sacrificial layer SL3 (S210) may include a photolithography process.

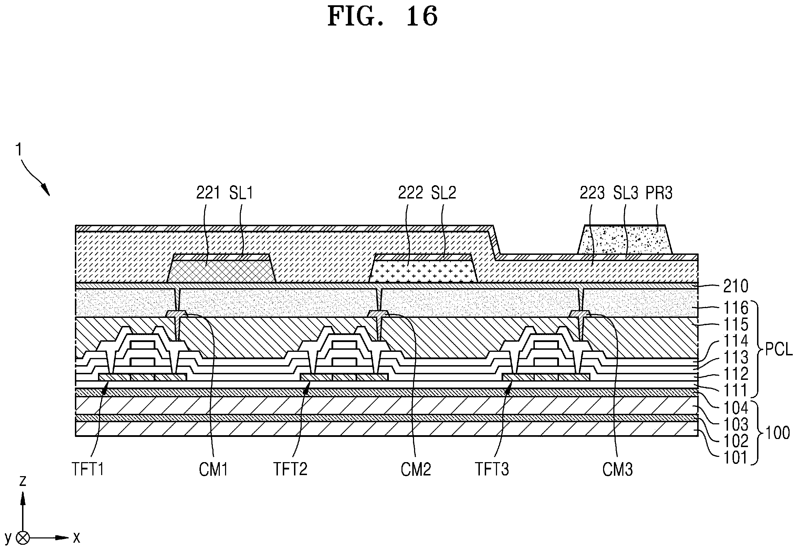

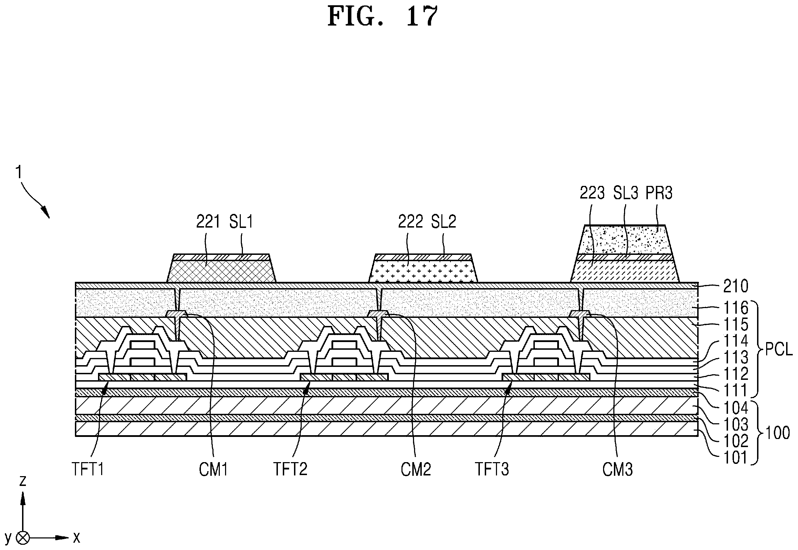

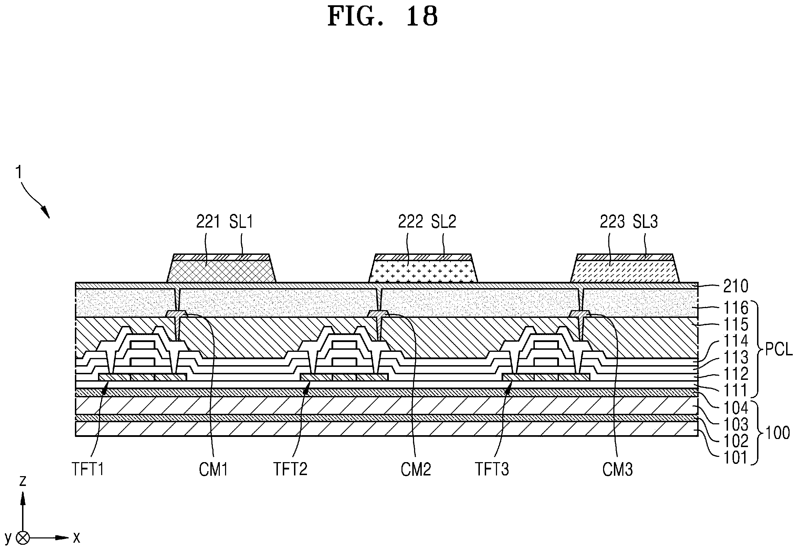

Referring to FIG. 16, a third photoresist layer PR3 that is patterned may be disposed on the third sacrificial layer SL3. Referring to FIG. 17, the third intermediate layer 223 and the third sacrificial layer SL3 may be etched. For example, the third intermediate layer 223 and the third sacrificial layer SL3 may be dry-etched by using an etching gas. In this process, the third intermediate layer 223 and the third sacrificial layer SL3, overlapping the third photoresist layer PR3, may remain. The third intermediate layer 223 and the third sacrificial layer SL3, which do not overlap the third photoresist layer PR3, may be etched and removed. Referring to FIG. 18, the third photoresist layer PR3 may be removed.

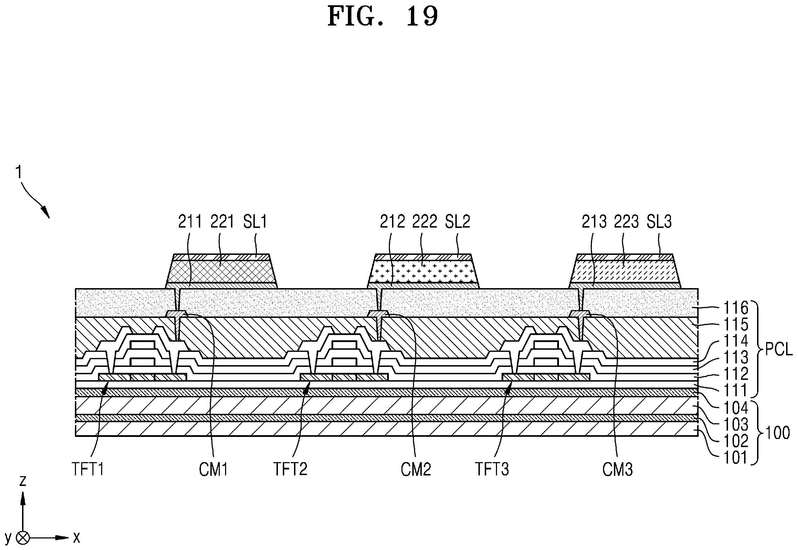

Referring to FIGS. 5 and 19, the arranging of the display element layer DEL on the pixel circuit layer PCL (S2) may include forming the first pixel electrode 211 (S2111), forming the second pixel electrode 212 (S2112), and forming the third pixel electrode 213 (S2113).

For example, the pixel electrode layer 210 may be dry-etched by using an etching gas. In this state, the first sacrificial layer SL1, the second sacrificial layer SL2, and the third sacrificial layer SL3 may function as a mask.

In other words, the forming of the first pixel electrode 211 (S2111) may include etching the pixel electrode layer 210 by using the first sacrificial layer SL1 as a mask. Furthermore, the forming of the second pixel electrode 212 (S2112) may include etching the pixel electrode layer 210 by using the second sacrificial layer SL2 as a mask. The forming of the third pixel electrode 213 (S2113) may include etching the pixel electrode layer 210 by using the third sacrificial layer SL3 as a mask. The forming of the first pixel electrode 211 (S2111), the forming of the second pixel electrode 212 (S2112), and the forming of the third pixel electrode 213 (S2113) may be simultaneously performed.

Accordingly, the first pixel electrode 211 overlapping the first sacrificial layer SL1, the second pixel electrode 212 overlapping the second sacrificial layer SL2, and the third pixel electrode 213 overlapping the third sacrificial layer SL3 may remain.

In this process, the first pixel electrode 211 and the first intermediate layer 221 may be connected to each other without forming a step. In other words, the end portions of the first pixel electrode 211 and the first intermediate layer 221 may match each other. The side surfaces of the first pixel electrode 211 and the first intermediate layer 221 may be formed on a same plane.

Furthermore, the second pixel electrode 212 and the second intermediate layer 222 may be connected to each other without forming a step. In other words, the end portions of the second pixel electrode 212 and the second intermediate layer 222 may match each other. The side surfaces of the second pixel electrode 212 and the second intermediate layer 222 may be formed on a same plane.

The third pixel electrode 213 and the third intermediate layer 223 may be connected to each other without forming a step. In other words, the end portions of the third pixel electrode 213 and the third intermediate layer 223 may match each other. The side surfaces of the third pixel electrode 213 and the third intermediate layer 223 may be formed on a same plane.

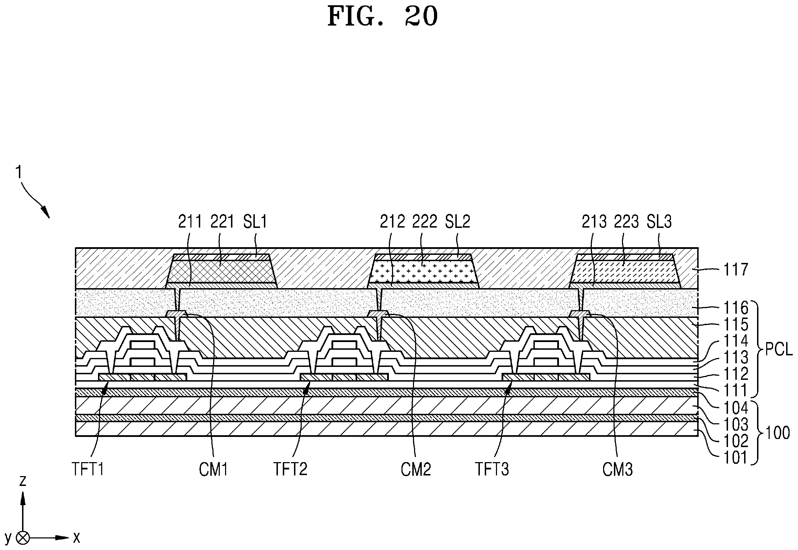

Referring to FIGS. 5 and 20, the arranging of the display element layer DEL on the pixel circuit layer PCL (S2) may include arranging the bank layer 117 on the pixel circuit layer PCL (S212).

The bank layer 117 may cover (or overlap) each of the pixel circuit layer PCL, the first pixel electrode 211, the second pixel electrode 212, the third pixel electrode 213, the first intermediate layer 221, the second intermediate layer 222, the third intermediate layer 223, the first sacrificial layer SL1, the second sacrificial layer SL2, and the third sacrificial layer SL3.

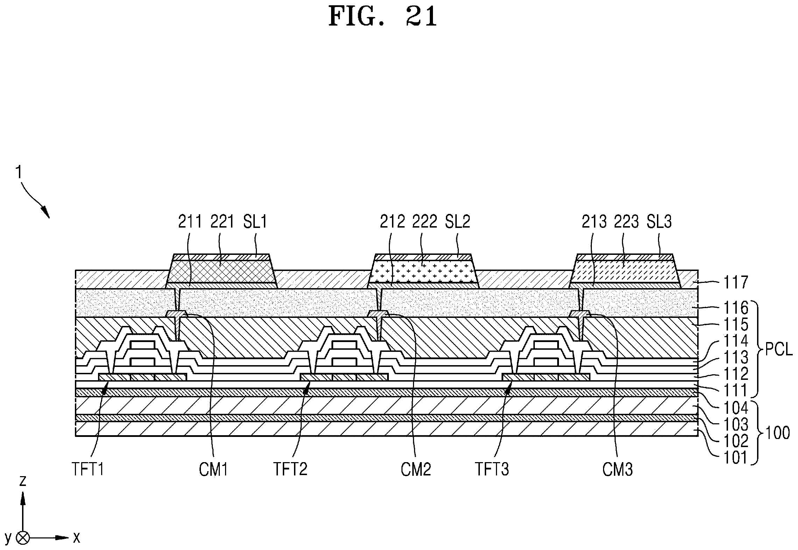

Referring to FIGS. 5 and 21, the arranging of the display element layer DEL on the pixel circuit layer PCL (S2) may include etching the bank layer 117 (S213).

The first sacrificial layer SL1, the second sacrificial layer SL2, and the third sacrificial layer SL3 may be exposed from the bank layer 117. Furthermore, portions of the first intermediate layer 221, the second intermediate layer 222, and the third intermediate layer 223 may be exposed from the bank layer 117. The heights of the first intermediate layer 221, the second intermediate layer 222, and the third intermediate layer 223 may be greater than the height of the bank layer 117 that is etched.

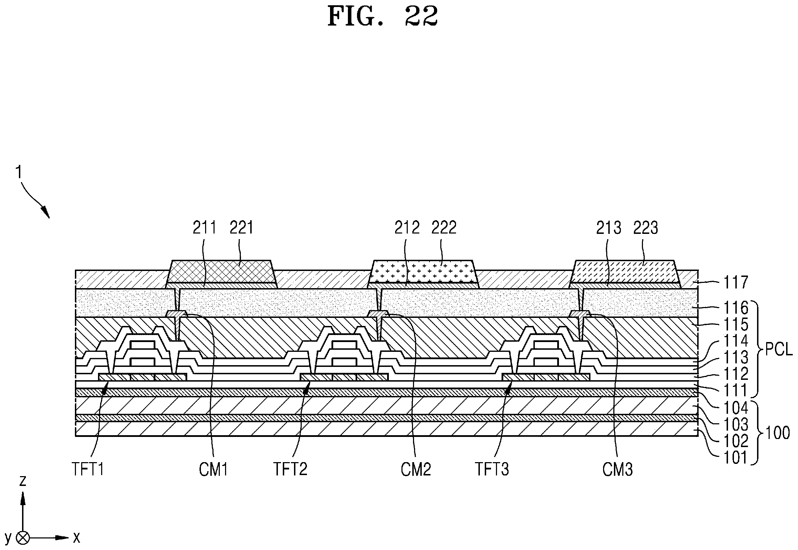

Referring to FIGS. 5 and 22, the arranging of the display element layer DEL on the pixel circuit layer PCL (S2) may include removing each of the first sacrificial layer SL1, the second sacrificial layer SL2, and the third sacrificial layer SL3 (S214).

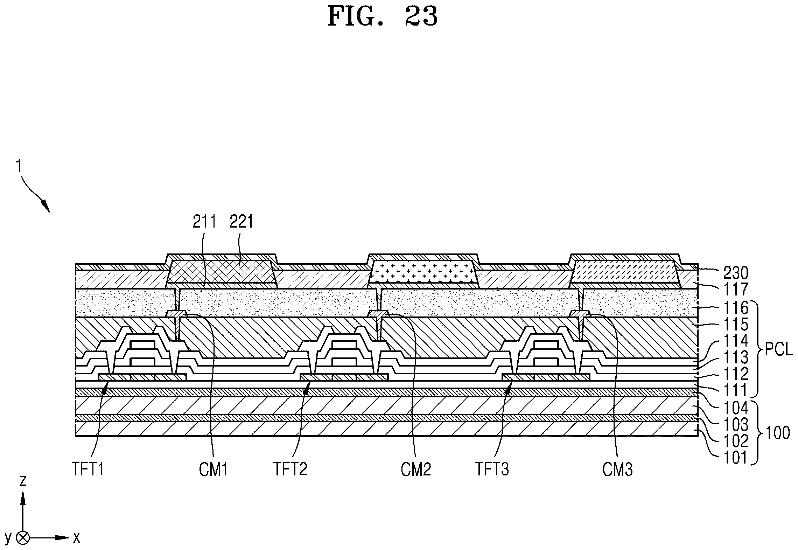

Referring to FIGS. 5 and 23, the arranging of the display element layer DEL on the pixel circuit layer PCL (S2) may include arranging the common electrode 230 on the bank layer 117 (S215). The common electrode 230 may cover (or overlap) the bank layer 117, the first intermediate layer 221, the second intermediate layer 222, and the third intermediate layer 223. The common electrode 230 may be electrically connected to the first intermediate layer 221, the second intermediate layer 222, and the third intermediate layer 223. A difference in the height of the common electrode 230 may be reduced due to the arrangement of the bank layer 117. In this structure, a short-circuit or disconnection of the common electrode 230 may be reduced.

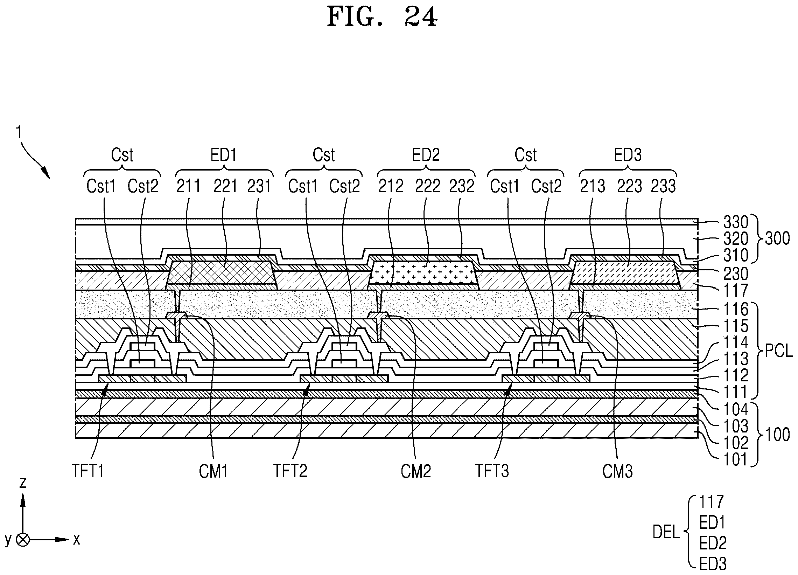

Referring to FIGS. 4 and 24, the method 2 of manufacturing a display device may include arranging the encapsulation layer 300 on the display element layer DEL (S3).

The first inorganic encapsulation layer 310 may be disposed on the display element layer DEL, the organic encapsulation layer 320 may be disposed on the first inorganic encapsulation layer 310, and the second inorganic encapsulation layer 330 may be disposed on the organic encapsulation layer 320.

Finally, the first pixel electrode 211, the first intermediate layer 221, and the first common electrode 231 may constitute the first light-emitting element ED1. Furthermore, the second pixel electrode 212, the second intermediate layer 222, and the second common electrode 232 may constitute the second light-emitting element ED2. The third pixel electrode 213, the third intermediate layer 223, and the third common electrode 233 may constitute the third light-emitting element ED3.

According to the embodiments, by simplifying a display device manufacturing process, the costs and time spent for manufacturing a display device may be reduced.

The above description is an example of technical features of the disclosure, and those skilled in the art to which the disclosure pertains will be able to make various modifications and variations. Thus, the embodiments of the disclosure described above may be implemented separately or in combination with each other.

## Claims

1. A display device (1) comprising:
a pixel circuit layer (PCL) disposed on a substrate (100); and
a display element layer (DEL) disposed on the pixel circuit layer (PCL), wherein
the display element layer (DEL) comprises:
a first light-emitting element (ED1), a second light-emitting element (ED2), and a third light-emitting element (ED3) which are spaced apart from one another; and
a bank layer (117) arranged between the first light-emitting element (ED1), the second light-emitting element (ED2), and the third light-emitting element (ED3),
wherein the first light-emitting element (ED1) comprises:
a first pixel electrode (211);
a first intermediate layer (221) disposed on the first pixel electrode (211); and
a first common electrode (231) disposed on the first intermediate layer (221),
the second light-emitting element (ED2) comprises:
a second pixel electrode (212);
a second intermediate layer (222) disposed on the second pixel electrode (212); and
a second common electrode (232) disposed on the second intermediate layer (222), the third light-emitting element (ED3) comprises:
a third pixel electrode (213);
a third intermediate layer (223) disposed on the third pixel electrode (213); and
a third common electrode (233) disposed on the third intermediate layer (223), and
a height of each of the first intermediate layer (221), the second intermediate layer (222), and the third intermediate layer (223) is greater than a height of the bank layer (117).

2. The display device (1) of claim 1, wherein the first common electrode (231), the second common electrode (232), and the third common electrode (233) are electrically connected to one another.

3. The display device of claim 1 or 2, wherein the first common electrode (231), the second common electrode (232), and the third common electrode (233) are integral with each other.

4. The display device (1) of any one of claims 1 to 3, wherein the first pixel electrode (211) and the first intermediate layer (221), the second pixel electrode (212) and the second intermediate layer (222), and/or the third pixel electrode (213) and the third intermediate layer (223) are electrically connected to each other without forming a step.

5. The display device (1) of any one of claims 1 to 4, wherein the first light-emitting element (ED1), the second light-emitting element (ED2), and the third light-emitting element (ED3) are configured to emit light of different colors.

6. A method (2) of manufacturing a display device (1), the method (2) comprising:
arranging a pixel circuit layer (PCL) on a substrate (100) (S1); and
arranging a display element layer (DEL) on the pixel circuit layer (PCL) (S2),
wherein the arranging of the display element layer (DEL) comprises:
arranging a pixel electrode layer (210) on the pixel circuit layer (PCL) (S201);
arranging a first intermediate layer (221) on the pixel electrode layer (210) (S202);
arranging a first sacrificial layer (SL1) on the first intermediate layer (221) (S203);
patterning the first intermediate layer (221) and the first sacrificial layer (SL1) (S204); and
forming a first pixel electrode (211) (S2111) to overlap the first sacrificial layer (SL1), by patterning the pixel electrode layer (210); and/or
wherein the arranging of the display element layer (DEL) comprises:
arranging a second intermediate layer (222) on the pixel electrode layer (210) (S205);
arranging a second sacrificial layer (SL2) on the second intermediate layer (222) (S206);
patterning the second intermediate layer (222) and the second sacrificial layer (SL2) (S207); and
forming a second pixel electrode (212) (S2112) to overlap the second sacrificial layer (SL2), by patterning the pixel electrode layer (210), and
the forming of the first pixel electrode (211) and the forming of the second pixel electrode (212) are performed simultaneously; and/or
wherein the arranging of the display element layer (DEL) comprises:
arranging a third intermediate layer (223) on the pixel electrode layer (210) (S208);
arranging a third sacrificial layer (SL3) on the third intermediate layer (223) (209);
patterning the third intermediate layer (223) and the third sacrificial layer (SL3) (S210); and
forming a third pixel electrode (213) (S2113) to overlap the third sacrificial layer (SL3), by patterning the pixel electrode layer (210), and
the forming of the second pixel electrode (212) and the forming of the third pixel electrode (213) are performed simultaneously.

7. The method (2) of claim 6, wherein the forming of the first pixel electrode (211) comprises etching the pixel electrode layer (210) by using the first sacrificial layer (SL1) as a mask, the forming of the second pixel electrode (212) comprises etching the pixel electrode layer (210) by using the second sacrificial layer (SL2) as a mask, and/or the forming of the third pixel electrode (213) comprises etching the pixel electrode layer (210) by using the third sacrificial layer (SL3) as a mask.

8. The method (2) of claim 6 or 7, wherein the first pixel electrode (211) and the first intermediate layer (221) are electrically connected to each other without forming a step, the second pixel electrode (212) and the second intermediate layer (222) are electrically connected to each other without forming a step, and/or the third pixel electrode (213) and the third intermediate layer (223) are connected to each other without forming a step.

9. The method (2) of any one of claims 6 to 8, wherein the arranging of the display element layer (DEL) further comprises arranging a bank layer (117) on the pixel circuit layer (PCL) (S212) to cover each of the first sacrificial layer (SL1), the second sacrificial layer (SL2), and the third sacrificial layer (SL3).

10. The method (2) of claim 9, wherein the arranging of the display element layer (DEL) further comprises etching the bank layer (117) (S213) to expose portions of the first intermediate layer (221), the second intermediate layer (222), and the third intermediate layer (223).

11. The method (2) of claim 10, wherein a height of each of the first intermediate layer (221), the second intermediate layer (222), and the third intermediate layer (223) is greater than a height of the bank layer (117) that is etched.

12. The method (2) of claim 10 or 11, wherein the bank layer (117) is in contact with all side surfaces of the first pixel electrode (211), the second pixel electrode (212), and the third pixel electrode (213) to insulate the first pixel electrode, the second pixel electrode, and the third pixel electrode.

13. The method (2) of any one of claims 10 to 12, wherein the arranging of the display element layer (DEL) further comprises removing each of the first sacrificial layer (SL1), the second sacrificial layer (SL2), and the third sacrificial layer (SL3) (S214).

14. The method (2) of any one of claims 9 to 13, wherein the arranging of the display element layer (DEL) further comprises arranging a common electrode (230) on the bank layer (117) (S215) to cover the first intermediate layer (221), the second intermediate layer (222), and the third intermediate layer (223).

15. The method (2) of claim 14, wherein the common electrode (230) is electrically connected to each of the first intermediate layer (221), the second intermediate layer (222), and the third intermediate layer (223).
